# EUROPÄISCHE PATENTANMELDUNG

(11) **EP 4 287 801 A1**
(43) Veröffentlichungstag der Anmeldung: **06.12.2023**
(21) Anmeldenummer: 23020137.8
(22) Anmeldetag: 17.03.2023
(51) Int. Cl.: H05K 7/20

(54) **PULSWECHSELRICHTER MIT EINER KÜHLEINRICHTUNG SOWIE KRAFTFAHRZEUG MIT EINEM PULSWECHSELRICHTER**

(30) Priorität: 03.06.2022 DE 102022114113
(71) Anmelder: Dr. Ing. h.c. F. Porsche Aktiengesellschaft, 70435 Stuttgart (DE)
(72) Erfinder: Wachter, Sebastian, 96332 Pressig (DE); Kleindienst, Maurice, 76744 Wörth am Rhein (DE)

(57) **Zusammenfassung**

Die Erfindung betrifft einen Pulswechselrichter (3) zum Betreiben einer elektrischen Maschine eines Kraftfahrzeugs, wobei der Pulswechselrichter ein Leistungsmodul (4) aufweist zur Wandlung von Gleichstrom, der von einer Kraftfahrzeugbatterie (1) bereitgestellt wird, in Wechselstrom, wobei der Pulswechselrichter (3) eine Kühleinrichtung aufweist zum Kühlen von Komponenten des Pulswechselrichters (3) mittels eines die Kühleinrichtung durchströmenden elektrisch isolierenden Kühlfluids, wobei die Kühleinrichtung ein fluiddichtes Gehäuse aufweist, wobei das das fluiddichte Gehäuse durchströmende Kühlfluid in direktem Kontakt mit zumindest einer der zu kühlenden Komponenten steht, wobei die Kühleinrichtung einen Kühlkanal (10) aufweist, wobei das Leistungsmodul (4) mit einer Außenfläche des Kühlkanals (10) thermisch verbunden ist, wobei der Kühlkanal (10) einen Ausgang (11) aufweist, wobei der Ausgang (11) in das fluiddichte Gehäuse mündet, sodass das die Kühleinrichtung durchströmende Kühlfluid zunächst den Kühlkanal (10) und anschließend das fluiddichte Gehäuse durchströmt.

## Beschreibung

Die vorliegende Erfindung betrifft einen Pulswechselrichter mit einer Kühleinrichtung sowie ein Kraftfahrzeug mit einem Pulswechselrichter. Ein Pulswechselrichter dient dazu, Gleichstrom in Wechselstrom zu wandeln, um eine elektrische Maschine mit Wechselstrom zu betreiben. Dementsprechend wird bei einem elektrisch oder teilelektrisch betriebenen Kraftfahrzeug der aus einer Kraftfahrzeugbatterie, in der Regel einer Hochvoltbatterie, zur Verfügung gestellte Gleichstrom durch den zwischengeschalteten Pulswechselrichter in Wechselstrom gewandelt. Auch die umgekehrte Richtung kann vorgesehen sein, also die Umwandlung von Wechselstrom in Gleichstrom, beispielsweise wenn die elektrische Maschine in einem Generatorbetrieb betrieben wird.

Ein Pulswechselrichter verfügt in der Regel über mehrere Phasensysteme, die jeweils zumindest ein Leistungsmodul mit einem Halbleiterbauelement aufweisen. Mittels des Halbleiterbauelements, insbesondere Halbleiterschaltern, kann beispielsweise für das Umwandeln von Gleichstrom in Wechselstrom ein Außenleiter des jeweiligen Phasensystems periodisch geschaltet werden, sodass in dem Außenleiter ein Wechselstrom anliegt. Bei den Halbleiterbauelementen kann es sich beispielsweise um FETs (Feldeffekttransistoren) oder IGBTs (Insulated-Gate Bipolar Transistors) handeln. Es sind aber auch JFETs (Junction-Gate Field Effect Transistors) oder MOSFETs (Metal Oxide Semiconductor Field-Effect Transistors) denkbar.

Die Halbleiterbauelemente der Leistungsmodule haben einen ohmschen Widerstand, der bei einem Stromfluss zu Abwärme und somit zu einem Ansteigen der Temperatur führt. Um das oder die Leistungsmodule vor einer Überhitzung zu schützen, sind in der Regel Kühleinrichtungen vorgesehen. Auch weitere Komponenten des Pulswechselrichters, wie beispielsweise Zwischenkreiskondensatoren oder Kontaktschienen haben einen ohmschen Widerstand, sodass auch diese Komponenten des Pulswechselrichters sich beim Betrieb des Pulswechselrichters erwärmen.

Aus der DE 10 2016 218 451 A1 ist es beispielsweise bekannt, die Leistungsmodule auf einem Kühlkörper zu montieren, wobei dieser Kühlkörper als Strangpressprofil ausgebildet ist.

Aufgabe der vorliegenden Erfindung ist es, einen Pulswechselrichter mit einer verbesserten Kühleinrichtung anzugeben, die eine besonders effiziente Kühlung des Pulswechselrichters gewährleistet. Ferner ist es Aufgabe der vorliegenden Erfindung, ein Kraftfahrzeug mit einem derartigen Pulswechselrichter anzugeben.

Diese Aufgaben werden durch die Gegenstände der unabhängigen Patentansprüche gelöst. Vorteilhafte Ausführungsformen sind Gegenstand der abhängigen Ansprüche.

Der erfindungsgemäße Pulswechselrichter dient zum Betreiben einer elektrischen Maschine eines Kraftfahrzeugs, insbesondere zum Betreiben eines Elektromotors. Der Pulswechselrichter weist zumindest ein Leistungsmodul auf, wobei dieses Leistungsmodul zur Umwandlung von Gleichstrom, der von einer Kraftfahrzeugbatterie bereitgestellt wird, in Wechselstrom dient. Der Pulswechselrichter weist eine Kühleinrichtung zum Kühlen von Komponenten des Pulswechselrichters mittels eines die Kühleinrichtung durchströmenden elektrisch isolierenden Kühlfluids auf. Die Kühleinrichtung weist ein fluiddichtes Gehäuse auf, das von dem elektrisch isolierenden Kühlfluid durchströmt wird, wobei das das fluiddichte Gehäuse durchströmende Kühlfluid in direktem Kontakt mit einer der zu kühlenden Komponenten des Pulswechselrichters steht. Die Kühleinrichtung weist ferner einen Kühlkanal auf, wobei das Leistungsmodul mit einer Außenfläche des Kühlkanals thermisch verbunden ist, wobei der Kühlkanal einen Ausgang aufweist, wobei der Ausgang in das fluiddichte Gehäuse mündet, sodass die Kühleinrichtung durchströmendes Kühlfluid zunächst den Kühlkanal und anschließend das fluiddichte Gehäuse durchströmt.

Der Vorteil der vorgenannten Gestaltung der Kühleinrichtung besteht darin, dass das relativ kalte Kühlfluid zunächst den Kühlkanal durchströmt, wodurch das Leistungsmodul besonders effizient gekühlt wird, da das Leistungsmodul mit dem Kühlkanal in thermischem Kontakt steht und somit das in dem Kühlkanal strömende relativ kalte Kühlfluid zur Kühlung des Leistungsmoduls verwendet wird. Das Leistungsmodul ist in der Regel diejenige Komponente des Pulswechselrichters, die den größten Kühlbedarf hat. Der Kühlbedarf von weiteren Komponenten, wie beispielsweise von Kontaktschienen und/oder von Zwischenkreiskondensatoren, hingegen ist in der Regel geringer als der Kühlbedarf von Leistungsmodulen. Erst im Anschluss an den Kühlkanal strömt das dann durch die Abwärme der Leistungsmodule erwärmte Kühlfluid in das fluiddichte Gehäuse ein und kommt somit in direkten Kontakt mit weiteren Komponenten und/oder dem Leistungsmodul, um diese zu Kühlen, und erwärmt sich dabei weiter. Durch die erfindungsgemäße Gestaltung kann eine besonders effiziente und ausreichende Kühlung des Leistungsmoduls erreicht werden, da gezielt relativ kaltes Kühlfluid zu den Leistungsmodulen geleitet wird und das Kühlfluid erst anschließend das fluiddichte Gehäuse flutet und somit erst anschließend in direkten Kontakt mit der oder den weiteren zu kühlenden Komponenten des Pulswechselrichters kommt. Wenn lediglich sämtliche Komponenten in der gleichen Art gekühlt würden, beispielsweise durch Flutung eines fluiddichten Pulswechselrichtergehäuses, somit ohne gezielte Leitung von relativ kaltem Kühlfluid zu dem Leistungsmodul, insbesondere den Leistungsmodulen, wäre ggf. keine ausreichende Kühlung des jeweiligen Leistungsmoduls gewährleistet oder das Kühlfluid müsste für eine ausreichende Kühlung eine niedrigere Temperatur aufweisen oder der Volumenstrom erhöht werden, wodurch ein Energiebedarf des Kühlsystems erhöht wäre.

Als besonders vorteilhaft wird es angesehen, wenn der Pulswechselrichter mehrere Leistungsmodule aufweist, wobei die mehreren Leistungsmodule mit der Außenfläche desselben Kühlkanals thermisch verbunden sind. Insofern dient ein und derselbe Kühlkanal dem Kühlen von mehreren Leistungsmodulen.

Es wird als besonders vorteilhaft angesehen, wenn das Leistungsmodul in direkten Kontakt mit dem in dem fluiddichten Gehäuse strömenden Kühlfluid steht. Insofern erfolgt in Strömungsrichtung des Kühlfluids zunächst eine indirekte Kühlung der Leistungsmodule über den Kühlkanal und anschließend eine direkte Kühlung der Leistungsmodule über direkten Kontakt mit dem Kühlfluid.

Als besonders vorteilhaft wird es angesehen, wenn das Leistungsmodul als solches wiederum ein fluiddichtes Leistungsmodulgehäuse aufweist, wobei innerhalb des Leistungsmodulgehäuses die Halbleiterbauelemente oder das Halbleiterbauelement angeordnet sind. Durch dieses fluiddichte Leistungsmodulgehäuse wird sichergestellt, dass die Halbleiterbauelemente nicht in direkten Kontakt mit dem Kühlfluid kommen, wodurch eine Beschädigung der Leistungselektronik bzw. der Halbleiterbauelemente aufgrund von leitfähigen Verunreinigungen des Kühlfluids vermieden werden.

Vorzugsweise ist das Leistungsmodul innerhalb des fluiddichten Gehäuses des Pulswechselrichters angeordnet.

Vorzugsweise bildet das fluiddichte Gehäuse ein Pulswechselrichtergehäuse, das sämtliche Komponenten des Pulswechselrichters umschließt.

Als besonders vorteilhaft wird es angesehen, wenn der Kühlkanal derart angeordnet ist, dass das fluiddichte Gehäuse durchströmende Kühlfluid eine oder sämtliche Außenflächen des Kühlkanals kontaktiert. Als besonders vorteilhaft wird es angesehen, wenn der Kühlkanal innerhalb des fluiddichten Gehäuses angeordnet ist, derart, dass das das Gehäuse durchströmende Kühlfluid den Kühlkanal umströmt. Insofern wird der Kühlkanal an seiner Außenseite und an seiner Innenseite von dem Kühlfluid umströmt. Vorzugsweise umströmt das in dem fluiddichten Gehäuse strömende Kühlfluid den Kühlkanal entgegengesetzt zu der Strömungsrichtung des Kühlfluids in dem Kühlkanal. Durch die Umkehr der Strömungsrichtung kann eine möglichst homogene Kühlung erreicht werden.

Bei dem elektrisch isolierenden Kühlfluid handelt es sich insbesondere um ein dielektrisches Kühlfluid, vorzugsweise um ein Kühlöl.

In einer bevorzugten Ausführungsform ist vorgesehen, dass in dem fluiddichten Gehäuse mehrere Leistungsmodule, mehrere Zwischenkreiskondensatoren und mehrere mit den Leistungsmodulen verbundene stromführende Kontaktschienen angeordnet sind, wobei das das Gehäuse durchströmende Kühlfluid in direkten Kontakt mit den mehreren Leistungsmodulen, den mehreren Zwischenkreiskondensatoren und den mehreren stromführenden Kontaktschienen steht.

Der Kühlkanal ist vorzugsweise als Strangpressprofil ausgebildet. Es ist durchaus denkbar, dass in dem Kühlkanal eine Kühlstruktur eingebracht ist, beispielsweise eingeschrumpft oder verpresst ist, um eine gezielte Führung bzw. Leitung des Kühlfluids in dem Kühlkanal zu erreichen.

In einer bevorzugten Ausführungsform ist das jeweilige Leistungsmodul stoffschlüssig mit der Außenfläche des Kühlkanals verbunden, beispielsweise verlötet oder verklebt. Als besonders vorteilhaft wird es angesehen, wenn das Leistungsmodul eine außenliegende Kühlplatte, beispielsweise aus Kupfer, aufweist, wobei diese Kühlplatte die Außenfläche des Kühlkanals kontaktiert. Dadurch kann eine besonders effiziente indirekte Kühlung erreicht werden. In diesem Zusammenhang wird es als besonders vorteilhaft angesehen, wenn ein Leistungsmodulgehäuse des Leistungsmoduls einen Innenraum des Leistungsmoduls fluiddicht umschließt, wobei die Kühlplatte freiliegend ist und den Kühlkanal kontaktiert.

Als besonders vorteilhaft wird es angesehen, wenn der Kühlkanal zwischen den Leistungsmodulen und den Zwischenkreiskondensatoren ausgebildet ist.

In einer bevorzugten Ausführungsform ist vorgesehen, dass die Kühleinrichtung einen weiteren Kühlkanal aufweist, wobei die Zwischenkreiskondensatoren thermisch mit einer Außenfläche des weiteren Kühlkanals verbunden sind, wobei der weitere Kühlkanal einen Ausgang aufweist, wobei der Ausgang des weiteren Kühlkanals in den einen Kühlkanal mündet, sodass das die Kühleinrichtung durchströmende Kühlfluid zunächst den weiteren Kühlkanal, anschließend den einen Kühlkanal und anschließend das fluiddichte Gehäuse durchströmt.

In einer bevorzugten Ausführungsform ist vorgesehen, dass der Pulswechselrichter eine erste Reihe von Leistungsmodulen und einen der ersten Reihe der Leistungsmodule zugeordneten Kühlkanal aufweist, wobei die Leistungsmodule der ersten Reihe mit der Außenfläche des zugeordneten Kühlkanals thermisch verbunden sind, und wobei der Pulswechselrichter eine zweite Reihe von Leistungsmodulen und einen der zweiten Reihe von Leistungsmodulen zugeordneten Kühlkanal aufweist, wobei die Leistungsmodule der zweiten Reihe mit der Außenfläche des zugeordneten Kühlkanals thermisch verbunden sind, wobei die Ausgänge der beiden Kühlkanäle in dasselbe fluiddichte Gehäuse münden, sodass die Kühleinrichtung durchströmendes Kühlfluid zunächst den jeweiligen Kühlkanal durchströmt und anschließend das Gehäuse durchströmt.

Das erfindungsgemäße Kraftfahrzeug weist eine Kraftfahrzeugbatterie, eine elektrische Maschine und einen Pulswechselrichter zum Betreiben der elektrischen Maschine auf. Der Pulswechselrichter weist ein Leistungsmodul auf, zur Wandlung von Gleichstrom, der von der Kraftfahrzeugbatterie bereitgestellt wird, in Wechselstrom. Der Pulswechselrichter weist eine Kühleinrichtung auf zum Kühlen von Komponenten des Pulswechselrichters mittels eines die Kühleinrichtung durchströmenden elektrisch isolierenden Kühlfluids. Die Kühleinrichtung weist ein fluiddichtes Gehäuse auf, wobei das das fluiddichte Gehäuse durchströmende Kühlfluid in direkten Kontakt mit einer der zu kühlenden Komponenten steht. Die Kühleinrichtung weist ferner einen Kühlkanal auf, wobei das Leistungsmodul mit einer Außenfläche des Kühlkanals thermisch verbunden ist, wobei der Kühlkanal einen Ausgang aufweist, wobei der Ausgang in das fluiddichte Gehäuse mündet, sodass die Kühleinrichtung durchströmendes Kühlfluid zunächst dem Kühlkanal und anschließend das fluiddichte Gehäuse durchströmt.

Als besonders vorteilhaft wird es angesehen, wenn das Kraftfahrzeug eine Maschinenkühlung zum Kühlen der elektrischen Maschine aufweist, wobei aus dem fluiddichten Gehäuse ausströmendes Kühlfluid in die Maschinenkühlung einströmt.

In diesem Zusammenhang wird es als besonders vorteilhaft angesehen, wenn das von der Kühleinrichtung zu der Maschinenkühlung strömende Kühlfluid Kontaktschienen, die den Pulswechselrichter mit der elektrischen Maschine elektrisch verbinden, direkt kontaktiert und dadurch kühlt.

Die im Zusammenhang mit dem Pulswechselrichter beschriebenen vorteilhaften Ausführungsformen gelten entsprechend für das Kraftfahrzeug und umgekehrt.

In den nachfolgenden Figuren wird die Erfindung anhand von Ausführungsbeispielen näher erläutert, ohne auf diese beschränkt zu sein. Es zeigen:
- Fig. 1: ein Antriebssystem eines elektrisch oder teilelektrisch angetriebenen Fahrzeugs in einer schematischen Darstellung,
- Fig. 2: eine Innenansicht eines Pulswechselrichters in einer schematischen Darstellung,
- Fig. 3: eine Innenansicht des Pulswechselrichters in einer perspektivischen Darstellung,
- Fig. 4: die Innenansicht des Pulswechselrichters gemäß Fig. 3 mit schematisch dargestellten Strömungsrichtungen des Kühlfluids,
- Fig. 5: eine Ausführungsform eines Kühlkanals der Kühleinrichtung in einer perspektivischen Ansicht,
- Fig. 6: Bestandteile des Kühlkanals gemäß Fig. 5 in einer perspektivischen Darstellung,
- Fig. 7: eine weitere Ausführungsform des Kühlkanals in einer perspektivischen Darstellung,
- Fig. 8: eine erste Ausführungsform eines Kühlkreislaufs in einer schematischen Darstellung,
- Fig. 9: eine zweite Ausführungsform eines Kühlkreislaufs in einer schematischen Darstellung.

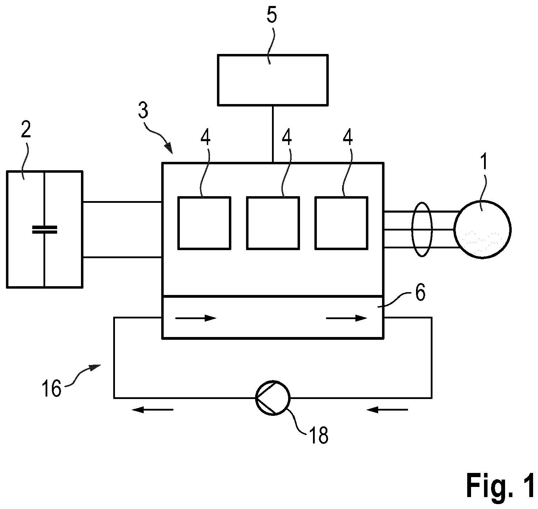

Die Fig. 1 zeigt Bestandteile eines Antriebssystems eines elektrisch oder teilelektrisch angetriebenen Fahrzeugs in einer schematischen Darstellung. Das Antriebssystem umfasst eine elektrische Maschine 1, eine Kraftfahrzeugbatterie 2 sowie einen Pulswechselrichter 3 zur Umwandlung des von der Kraftfahrzeugbatterie 2 bereitgestellten Gleichstroms in einen Wechselstrom zum Betreiben der elektrischen Maschine 1. Der Pulswechselrichter 3 weist dabei mehrere Leistungsmodule 4 auf, wobei diese Leistungsmodule 4 eine Leistungselektronik in Form von Halbleiterbauelementen aufweisen. Ferner umfasst das Antriebssystem eine Steuereinheit 5, wobei diese Steuereinheit 5 den Pulswechselrichter 3 in der Weise ansteuert, dass die Gleichspannung der Kraftfahrzeugbatterie 2 in eine Wechselspannung zum Antreiben der elektrischen Maschine 1 umgewandelt wird. Während des Betriebs des Pulswechselrichters 3 fließen durch die Halbleiterbauelemente der Leistungsmodule 4 sehr hohe elektrische Ströme. Die dabei entstehenden ohmschen Verluste führen zu einer Erwärmung der Leistungsmodule 4. Diese Wärme muss abgeführt werden. Zu diesem Zweck werden die Leistungsmodule 4 durch eine Kühleinrichtung 6 gekühlt, die Bestandteil eines Kühlkreislaufs 16 ist, in dem ein Kühlfluid strömt. Die Strömungsrichtung des Kühlfluids ist durch die Pfeile in der Fig. 1 angedeutet.

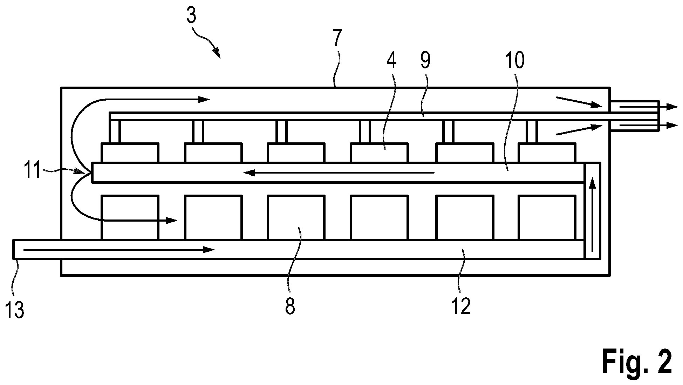

Die Ausgestaltung der Kühleinrichtung 6 des Pulswechselrichters 3 ist in den Fig. 2 bis 4 näher dargestellt, wobei die Fig. 2 lediglich eine schematische Darstellung ist. Die Kühleinrichtung 6 umfasst ein fluiddichtes Gehäuse 7, wobei das das fluiddichte Gehäuse 7 durchströmende Kühlfluid in direkten Kontakt mit den zu kühlenden Komponenten steht. Bei den Komponenten des Pulswechselrichters 3, die direkt von dem Kühlfluid umströmt sind, handelt es sich vorliegend um die Leistungsmodule 4, Zwischenkreiskondensatoren 8 sowie Kontaktschienen 9. Bei dem Kühlfluid handelt es sich um ein dielektrisches Kühlfluid, beispielsweise ein Kühlöl. Daher kann eine direkte Kontaktierung der stromführenden Bauteile durch das Kühlfluid erfolgen ohne dass die Gefahr eines Kurzschlusses bzw. Stromflusses über das Kühlfluid besteht. Auf eine Isolation der stromführenden Komponenten, die sich nachteilig auf die Kühlwirkung auswirken würde, kann daher verzichtet werden.

Die Kühleinrichtung 6 weist einen Kühlkanal 10 auf, wobei der Kühlkanal 10 als Strangpressprofil ausgebildet ist. Die Leistungsmodule 4 sind unmittelbar mit einer Außenfläche des Kühlkanals 10 verlötet. Ein Ausgang 11 des Kühlkanals 10 mündet in das fluiddichte Gehäuse 7, sodass das die Kühleinrichtung 6 durchströmende Kühlfluid zunächst den Kühlkanal 10 und anschließend das fluiddichte Gehäuse 7 durchströmt. Mit anderen Worten flutet das am Ausgang 11 aus dem Kühlkanal 10 austretende Kühlöl den gesamten Innenraum des Pulswechselrichters 3, der von dem fluiddichten Gehäuse 7 umschlossen wird.

In der in den Fig. 2 bis 4 dargestellten Ausführungsform des Pulswechselrichters 3 ist der Kühlkanal 10 zwischen den Zwischenkreiskondensatoren 8 und den Leistungsmodulen 4 angeordnet. Ferner weist die Kühleinrichtung 6 einen weiteren Kühlkanal 12 auf, wobei dieser Kühlkanal 12 dem indirekten Kühlen der Zwischenkreiskondensatoren 8 dient. Zu diesem Zweck sind die Zwischenkreiskondensatoren 8 mit einer Außenfläche des weiteren Kühlkanals 12 thermisch verbunden. Der weitere Kühlkanal 12 weist einen Eingang 13 für das Kühlfluid auf und mündet in den einen Kühlkanal 10, der dem Kühlen der Leistungsmodule 4 dient. Dementsprechend durchströmt das die Kühleinrichtung 6 durchströmende Kühlfluid zunächst den weiteren Kanal 12, anschließend den einen Kühlkanal 10 und anschließend das fluiddichte Gehäuse 7.

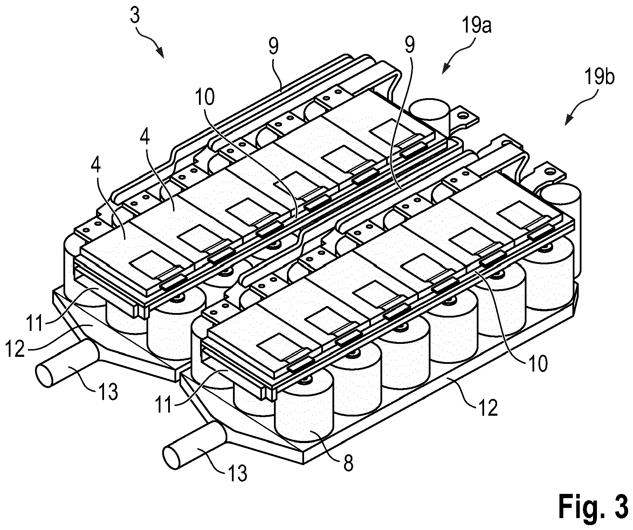

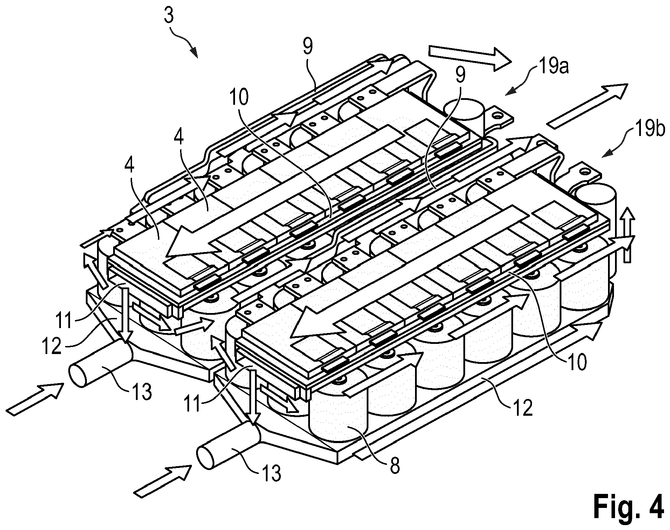

Wie insbesondere den Fig. 3 und 4 zu entnehmen ist, weist der Pulswechselrichter 3 eine erste Reihe 19a von Leistungsmodulen 4 und eine zweite Reihe 19b von Leistungsmodulen 4 auf. Der jeweiligen Reihe 19a, 19b von Leistungsmodulen 4 ist ein eigener Kühlkanal 10 und den zugeordneten Zwischenkreiskondensatoren 8 jeweils ein weiterer Kühlkanal 12 zugeordnet. Die beiden vorgenannten Anordnungen sind dabei in demselben Gehäuse 7 angeordnet, das in den Fig. 3 und 4 nicht näherdargestellt ist.

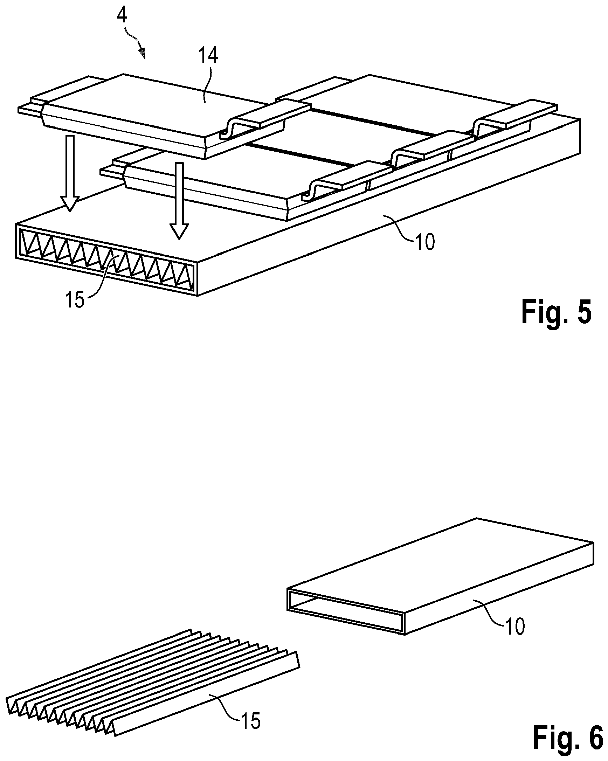

In der Fig. 5 ist der Kühlkanal 10 mit daran angeordneten Leistungsmodulen 4 näher dargestellt. Die Leistungsmodule 4 weisen jeweils ein geschlossenes, fluiddichtes Leistungsmodulgehäuse 14 auf, welches von dem in dem Gehäuse 6 strömenden Kühlfluid direkt umströmt wird. Das Leistungsmodulgehäuse 14 verhindert, dass das Kühlfluid die Halbleiterbauelemente direkt kontaktiert. Die Leistungsmodule 14 sind im Bereich einer Unterseite des jeweiligen Leistungsmoduls 4 mit dem Kühlkanal 10 verlötet. Zur besseren Wärmeleitung weist das jeweilige Leistungsmodul 4 an seiner Unterseite eine wärmeleitende Kühlplatte aus Kupfer auf.

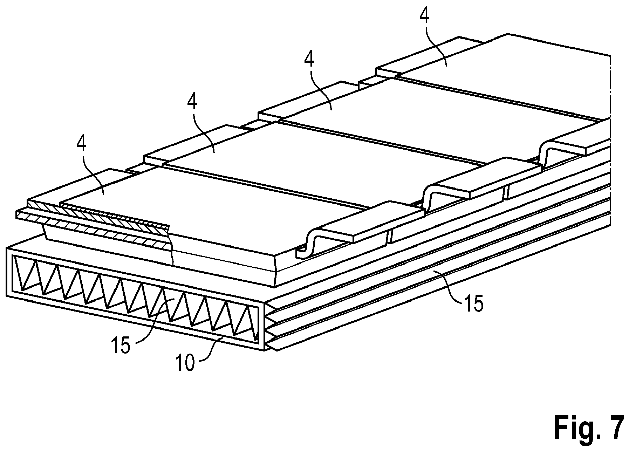

In dem Kühlkanal 10 ist eine wellenförmige Kühlstruktur 15 eingebracht, um die Wärmeübertragung von den Leistungsmodulen 4 auf das in dem Kühlkanal 10 strömende Kühlfluid zu verbessern. Eine derartige Kühlstruktur 15 kann auch an einer Außenfläche des Kühlkanals 10 angebracht sein, wie dies exemplarisch in der Fig. 7 gezeigt ist.

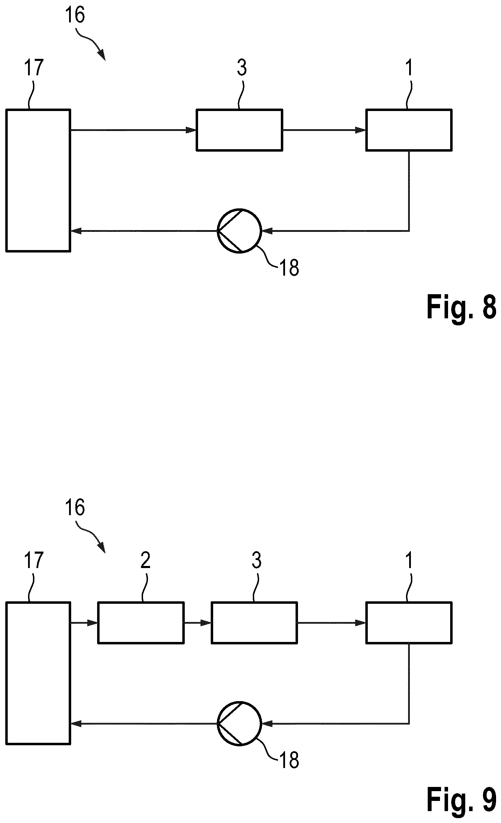

Die Fig. 8 zeigt einen beispielhaften Kühlkreislauf 16 in einem Kraftfahrzeug, das den erfindungsgemäßen Pulswechselrichter 3 umfasst. In dem Kühlkreislauf 16 zirkuliert das dielektrische Kühlöl, wobei der Kühlkreislauf 16 einen Wärmetauscher 17 und eine Pumpe 18 aufweist, wobei in Strömungsrichtung des Kühlfluids der Pulswechselrichter 3 vor der elektrischen Maschine 1 angeordnet ist. Dementsprechend wird zunächst der Pulswechselrichter 3 durchströmt und im Anschluss daran die elektrische Maschine 1 durchströmt. Als besonders vorteilhaft wird es in diesem Zusammenhang angesehen, wenn das aus dem Gehäuse 7 ausströmende Kühlfluid der elektrischen Maschine 1 bzw. der Maschinenkühlung der elektrischen Maschine 1, derart zugeführt wird, dass die Kontaktschienen 9, die den Pulswechselrichter 3 mit der elektrischen Maschine 1 elektrisch verbinden, von dem Kühlfluid direkt kontaktiert und auf diese Weise gekühlt werden. Die Fig. 9 zeigt eine weitere Ausführungsform des Kühlkreislaufs 16, wobei sich diese Ausführungsform von der Ausführungsform gemäß Fig. 8 im Wesentlichen dadurch unterscheidet, dass die Kraftfahrzeugbatterie 2 ebenfalls von dem Kühlfluid durchströmt wird zwecks Kühlung der Kraftfahrzeugbatterie 2, wobei die Kraftfahrzeugbatterie 2 in Strömungsrichtung des Kühlfluids vor dem Pulswechselrichter 3 angeordnet ist. Von der Hochvoltbatterie 2 in Richtung des Pulswechselrichters 3 strömendes Kühlfluid kontaktiert Kontaktschienen 9, die die Hochvoltbatterie 2 mit dem Pulswechselrichter 3 elektrisch verbinden, direkt um diese zu Kühlen.

### Bezugszeichenliste

- 1: elektrische Maschine
- 2: Kraftfahrzeugbatterie
- 3: Pulswechselrichter
- 4: Leistungsmodul
- 5: Steuerung
- 6: Kühleinrichtung
- 7: Gehäuse
- 8: Zwischenkreiskondensator
- 9: Kontaktschiene
- 10: Kühlkanal
- 11: Ausgang
- 12: weiterer Kühlkanal
- 13: Eingang
- 14: Leistungsmodulgehäuse
- 15: Kühlstruktur
- 16: Kühlkreislauf
- 17: Wärmetauscher
- 18: Pumpe
- 19: Reihe

## Patentansprüche

1. Pulswechselrichter (3) zum Betreiben einer elektrischen Maschine (1) eines Kraftfahrzeugs, wobei der Pulswechselrichter (3) ein Leistungsmodul (4) aufweist zur Wandlung von Gleichstrom, der von einer Kraftfahrzeugbatterie (1) bereitgestellt wird, in Wechselstrom, wobei der Pulswechselrichter (3) eine Kühleinrichtung (6) aufweist zum Kühlen von Komponenten des Pulswechselrichters (3) mittels eines die Kühleinrichtung (6) durchströmenden elektrisch isolierenden Kühlfluids, wobei die Kühleinrichtung (6) ein fluiddichtes Gehäuse (7) aufweist, wobei das das fluiddichte Gehäuse (7) durchströmende Kühlfluid in direktem Kontakt mit zumindest einer der zu kühlenden Komponenten steht, wobei die Kühleinrichtung (6) einen Kühlkanal (10) aufweist, wobei das Leistungsmodul (4) mit einer Außenfläche des Kühlkanals (10) thermisch verbunden ist, wobei der Kühlkanal (10) einen Ausgang (11) aufweist, wobei der Ausgang (11) in das fluiddichte Gehäuse (7) mündet, sodass das die Kühleinrichtung (6) durchströmende Kühlfluid zunächst den Kühlkanal (10) und anschließend das fluiddichte Gehäuse (7) durchströmt.

2. Pulswechselrichter (3) nach Anspruch 1, wobei der Pulswechselrichter (3) mehrere Leistungsmodule (4) aufweist, wobei die mehreren Leistungsmodule (4) mit der Außenfläche des Kühlkanals (10) thermisch verbunden sind.

3. Pulswechselrichter (3) nach Anspruch 1 oder 2, wobei das Leistungsmodul (4) in direkten Kontakt mit dem in dem fluiddichten Gehäuse (7) strömenden Kühlfluid steht.

4. Pulswechselrichter nach einem der Ansprüche 1 bis 3, wobei der Kühlkanal (10) innerhalb des fluiddichten Gehäuses (6) angeordnet ist, derart, dass das das Gehäuse (7) durchströmende Kühlfluid den Kühlkanal (10) umströmt.

5. Pulswechselrichter nach einem der Ansprüche 1 bis 4, wobei in dem Gehäuse (7) mehrere Leistungsmodule (4), mehrere Zwischenkreiskondensatoren (8) und mehrere mit den Leistungsmodulen (4) verbundene stromführende Kontaktschienen (9) angeordnet sind, wobei das das Gehäuse (7) durchströmende Kühlfluid in direktem Kontakt mit den mehreren Leistungsmodulen (4), den mehrere Zwischenkreiskondensatoren (8) und den mehreren stromführenden Kontaktschienen (9) steht.

6. Pulswechselrichter nach einem der Ansprüche 1 bis 5, wobei die Kühleinrichtung (6) einen weiteren Kühlkanal (12) aufweist, wobei die Zwischenkreiskondensatoren (8) thermisch mit einer Außenfläche des weiteren Kühlkanals (12) verbunden sind, wobei der weitere Kühlkanal (12) einen Ausgang aufweist, wobei der Ausgang in den einen Kühlkanal (10) mündet, sodass das die Kühleinrichtung (6) durchströmendes Kühlfluid zunächst den weiteren Kühlkanal (12), anschließend den einen Kühlkanal (10) und anschließend das fluiddichte Gehäuse (7) durchströmt.

7. Pulswechselrichter nach einem der Ansprüche 1 bis 6, wobei das Leistungsmodul (4) ein fluiddichtes Leistungsmodulgehäuse (14) aufweist, wobei Halbleiterbauelemente des Leistungsmoduls (4) innerhalb des Leistungsmodulgehäuses (14) angeordnet sind.

8. Kraftfahrzeug aufweisend
- eine Kraftfahrzeugbatterie (2),
- eine elektrische Maschine (1), und
- einen Pulswechselrichter (3) zum Betreiben der elektrischen Maschine, wobei der Pulswechselrichter (3) ein Leistungsmodul (4) aufweist zur Wandlung von Gleichstrom, der von der Kraftfahrzeugbatterie (2) bereitgestellt wird, in Wechselstrom, wobei der Pulswechselrichter (3) eine Kühleinrichtung (6) aufweist zum Kühlen von Komponenten des Pulswechselrichters (3) mittels eines die Kühleinrichtung (6) durchströmenden elektrisch isolierenden Kühlfluids, wobei die Kühleinrichtung (6) ein fluiddichtes Gehäuse (7) aufweist, wobei das das fluiddichte Gehäuse (7) durchströmende Kühlfluid in direktem Kontakt mit zumindest einer der zu kühlenden Komponenten steht, wobei die Kühleinrichtung (6) einen Kühlkanal (10) aufweist, wobei das Leistungsmodul (4) mit einer Außenfläche des Kühlkanals (10) thermisch verbunden ist, wobei der Kühlkanal (10) einen Ausgang (11) aufweist, wobei der Ausgang (11) in das fluiddichte Gehäuse (7) mündet, sodass das die Kühleinrichtung (6) durchströmende Kühlfluid zunächst den Kühlkanal (10) und anschließend das fluiddichte Gehäuse (7) durchströmt.

9. Kraftfahrzeug nach Anspruch 8, wobei das Kraftfahrzeug eine Maschinenkühlung zum Kühlen der elektrischen Maschine (1) aufweist, wobei aus dem Gehäuse (7) ausströmendes Kühlfluid in die Maschinenkühlung einströmt.

10. Kraftfahrzeug nach Anspruch 8 oder 9, wobei das von der Kühleinrichtung (6) zu der Maschinenkühlung strömende Kühlfluid Kontaktschienen (9), die den Pulswechselrichter mit der elektrischen Maschine elektrisch verbinden, direkt kontaktiert.
